# EUROPÄISCHE PATENTSCHRIFT

(11) **EP 3 657 137 B1**
(45) Veröffentlichungstag und Bekanntmachung des Hinweises auf die Patenterteilung: **27.07.2022**
(21) Anmeldenummer: 19207332.8
(22) Anmeldetag: 06.11.2019
(51) Int. Cl.: G01D 21/00, G01K 1/02

(54) **TRANSMITTER UND FELDGERÄT**
TRANSMITTER AND FIELD DEVICE
ÉMETTEUR ET APPAREIL DE TERRAIN

(30) Priorität: 22.11.2018 DE 102018129437
(43) Veröffentlichungstag der Anmeldung: 27.05.2020
(73) Patentinhaber: Krohne Messtechnik GmbH, 47058 Duisburg (DE)
(72) Erfinder: Mårtensson, Hans-Owe, 23176 Beddingestrand (SE)
(74) Vertreter: Gesthuysen Patentanwälte

(56) Entgegenhaltungen:
- EP-A2- 2 784 651
- DE-A1-102014 106 540
- DE-A1-102016 207 826
- US-A1- 2010 013 462

## Beschreibung

Die Erfindung geht aus von einem Transmitter mit einem Transmittergehäuse, einer Elektronikeinheit und einer Anzeigeeinheit, wobei die Elektronikeinheit zur Anbindung an einen Messwertaufnehmer ausgebildet ist, wobei die Elektronikeinheit mit der Anzeigeeinheit verbunden ist und wobei das Transmittergehäuse wenigstens eine Kabelverschraubung aufweist.

Zudem betrifft die Erfindung ein Feldgerät mit einem Messwertaufnehmer und einem Transmitter, wobei der Transmitter ein Transmittergehäuse, eine Elektronikeinheit und eine Anzeigeeinheit aufweist, wobei die Elektronikeinheit mit dem Messwertaufnehmer verbunden ist, wobei die Elektronikeinheit mit der Anzeigeeinheit verbunden ist und wobei das Transmittergehäuse wenigstens eine Kabelverschraubung aufweist.

Bei dem Einsatz von Feldgeräten dienen Transmitter, die auch als Messwertumformer bezeichnet werden, der Auswertung und/oder der Weiterleitung der von dem Messwertaufnehmer erfassten primären Messsignale. Zur Auswertung und/oder zur Weiterleitung der Messsignale weist ein Transmitter eine Elektronikeinheit auf, die mit dem Messwertaufnehmer verbunden ist. Je nach Art des Feldgerätes bzw. des realisierten Messprinzips zur Aufnahme des primären Messsignals kann der Messwertaufnehmer ebenfalls mittels der Elektronikeinheit angesteuert werden.

Zur Verbindung der Elektronikeinheit beispielsweise mit einer Leitwarte weist das Transmittergehäuse üblicherweise Durchgänge in Form von wenigstens einer Kabelverschraubung auf, um eine dichte Kabeleinführung in das Transmittergehäuse zu gewährleisten.

Eine Art der Aufbereitung und der Weiterleitung der primären Messsignale besteht in der Ausgabe der interessierenden Messgröße über eine Anzeigeeinheit. Über die Anzeigeeinheit können gemäß einer Ausgestaltung neben der interessierenden Messgröße ebenfalls sekundäre Messgrößen und/oder relevante Prozessparameter angezeigt werden oder verschiedene Einstellungen beispielsweise in Bezug auf den Messbereich oder einen Grenzwert vorgenommen werden. Beispielsweise kann die Anzeigeeinheit ein Menü aufweisen, das über ein Bedienelement gesteuert werden kann. Hierfür ist eine Schnittstelle, über die dem Nutzer Zugriff auf die Anzeigeeinheit gewährt wird, erforderlich.

Gerade bei Transmittern, die in explosionsgefährdeten Anwendungen zum Einsatz kommen, ist jede Schnittstelle ins Transmittergehäuse eine potenzielle Schwachstelle, sodass besonders hohe Anforderungen an die Dichtigkeit eines solchen Durchgangs gestellt werden.

Aus der Druckschrift EP 2 784 651 A2 ist ein Transmitter bekannt, wobei ein Bedienelement der Anzeigeeinheit als Knopf und ein weiteres Bedienelement als Drehknopf ausgebildet ist.

Aus der Druckschrift DE 10 2016 207826 A1 ist ein anderer Transmitter bekannt, wobei der Signalausgang durch einen Steckverbinder erfolgt, und wobei in dem Steckverbinder eine Einstellschraube über die ein Potentiometer eingestellt werden kann, angeordnet ist.

Der Erfindung liegt ausgehend von dem genannten Stand der Technik die Aufgabe zugrunde, einen Transmitter anzugeben, der eine besonders einfache und sichere externe Bedienung erlaubt. Darüber hinaus liegt der Erfindung die Aufgabe zugrunde, ein Feldgerät umfassend einen entsprechenden Transmitter anzugeben.

Gemäß einer ersten Lehre der Erfindung wird die zuvor genannte Aufgabe durch einen eingangs beschriebenen Transmitter dadurch gelöst, dass in der wenigstens einen Kabelverschraubung wenigstens ein Verbindungsmodul angeordnet ist und dass das wenigstens eine Verbindungsmodul wenigstens ein Bedienelement zur Kommunikation mit der Anzeigeeinheit und/oder der Elektronikeinheit umfasst.

Erfindungsgemäß wurde erkannt, dass ein Verbindungsmodul umfassend ein Bedienelement, wobei das Verbindungsmodul derart ausgestaltet ist, dass es in einer Kabelverschraubung angeordnet werden kann, auf besonders einfache Weise in das Transmittergehäuse eingebracht werden kann und insofern eine besonders einfache und sichere Bedienung der Anzeigeeinheit und/oder der Elektronikeinheit gewährleistet werden kann.

Gemäß einer ersten Ausgestaltung ist die Kabelverschraubung als Panzergewindeverschraubung ausgebildet. Diese Ausgestaltung weist den Vorteil auf, dass eine besonders dichte Einführung des Verbindungsmoduls gewährleistet werden kann.

Weiterhin kann die wenigstens eine Kabelverschraubung alternativ oder zusätzlich ein metrisches Gewinde und/oder ein selbstdichtendes NPT-Gewinde aufweisen.

Gemäß einer nächsten Ausgestaltung weist das Verbindungsmodul ein Gewinde auf, wobei das Verbindungsmodul in die Kabelverschraubung derart eingeschraubt ist, dass das Verbindungsmodul als Stopfen die Kabelverschraubung dicht verschließt. Das Gewinde kann beispielsweise mittels eines Spritzgussverfahrens an das Verbindungsmodul angespritzt sein.

Vorzugsweise ist die Einheit aus der Kabelverschraubung und dem Verbindungsmodul derart ausgestaltet, dass die Anforderungen der Schutzart in Bezug auf den Schutz gegen Berührung, Eindringen von Fremdkörpern und Wasser sowie Stoßfestigkeit gemäß DIN EN 60529, IP 6X und/oder IP X7 und/oder IP X8 und/oder IP X9, insbesondere IP 67 und/oder IP 68 und/oder IP 69 erfüllt sind. Gemäß einer besonders bevorzugten Ausgestaltung wird diese Dichtigkeit allein durch die Gewindeverschraubung gewährleistet. Gemäß einer weiteren Ausgestaltung ist wenigstens ein weiteres Dichtelement, vorzugsweise in Form von einem Dichtungsring und/oder einer Beschichtung des Gewindes des Verbindungsmoduls vorhanden.

Gemäß einer nächsten Ausgestaltung umfasst das wenigstens eine Bedienelement ein analoges Bedienelement und/oder ein digitales Bedienelement.

Besonders bevorzugt ist das wenigstens eine Bedienelement als Taste und/oder als Druckknopf und/oder als Wippenschalter und/oder als Kippschalter und/oder als Drehschalter und/oder als Schieberegler und/oder als Fingerdrucksensor und/oder als optischer Sensor und/oder als Mikrofon und/oder als Steuerhebel ausgebildet.

Gemäß einer weiteren bevorzugten Ausgestaltung ist das Bedienelement als Drehgeber bzw. Encoder ausgebildet. Besonders bevorzugt kann über die Rotation des Drehgebers eine Auswahl aus dem auf der Anzeigeeinheit dargestellten Menü und/oder eine Änderung der Anzeige realisiert werden, wobei durch Drücken des Drehgebers eine Bestätigung der Einstellung bzw. der Auswahl erfolgt.

Weiterhin ist es vorteilhaft, wenn das Verbindungsmodul wenigstens eine drahtlose Schnittstelle und/oder eine Antenne und/oder eine optische Schnittstelle aufweist. Gemäß dieser Ausgestaltung kann eine Betätigung des Bedienelementes auch aus einiger Entfernung erfolgen, sodass der Transmitter auch dann für eine Kommunikation zugänglich ist, wenn er an schwer oder nicht erreichbaren Stellen platziert ist.

Gemäß einer nächsten Ausgestaltung ist das Bedienelement mittels einer Kabelverbindung mit der Anzeigeeinheit und/oder der Elektronikeinheit verbunden.

Gemäß einer nächsten vorteilhaften Ausgestaltung ist das Verbindungsmodul austauschbar in der Kabelverschraubung angeordnet. Hierzu ist das Verbindungsmodul lösbar in die Kabelverschraubung eingesetzt.

Weiterhin ist es vorteilhaft, wenn die Anzeigeeinheit in dem Verbindungsmodul angeordnet ist. Gemäß dieser Ausgestaltung ist eine Einheit aus Anzeigeeinheit und Bedienelement in die Kabelverschraubung vorzugsweise austauschbar eingesetzt. Beispielsweise kann das Bedienelement gemäß dieser Ausgestaltung als Deckel oder als Teil eines Gehäuses der Anzeigeeinheit ausgebildet sein.

Gemäß einer zweiten Lehre der vorliegenden Erfindung wird die eingangs genannte Aufgabe durch ein eingangs beschriebenes Feldgerät dadurch gelöst, dass in der wenigstens einen Kabelverschraubung wenigstens ein Verbindungsmodul angeordnet ist und dass das wenigstens eine Verbindungsmodul wenigstens ein Bedienelement zur Kommunikation mit der Anzeigeeinheit und/oder der Elektronikeinheit umfasst.

Besonders bevorzugt ist der Transmitter nach einer der zuvor beschriebenen Ausgestaltungen ausgebildet.

Im Einzelnen gibt es nun eine Vielzahl von Möglichkeiten, den erfindungsgemäßen Transmitter und das erfindungsgemäße Feldgerät auszugestalten und weiterzubilden. Dazu wird verwiesen sowohl auf die den unabhängigen Patentansprüchen nachgeordneten Patentansprüche als auch auf die nachfolgende Beschreibung von bevorzugten Ausführungsbeispielen in Verbindung mit der Zeichnung. In der Zeichnung zeigen
- Fig. 1: ein erstes Ausführungsbeispiel eines erfindungsgemäßen Transmitters bzw. eines erfindungsgemäßen Feldgerätes,
- Fig. 2: ein Ausführungsbeispiel eines Verbindungsmoduls und
- Fig. 3: ein zweites Ausführungsbeispiel eines erfindungsgemäßen Transmitters bzw. ein zweites Ausführungsbeispiel eines Feldgeräts.

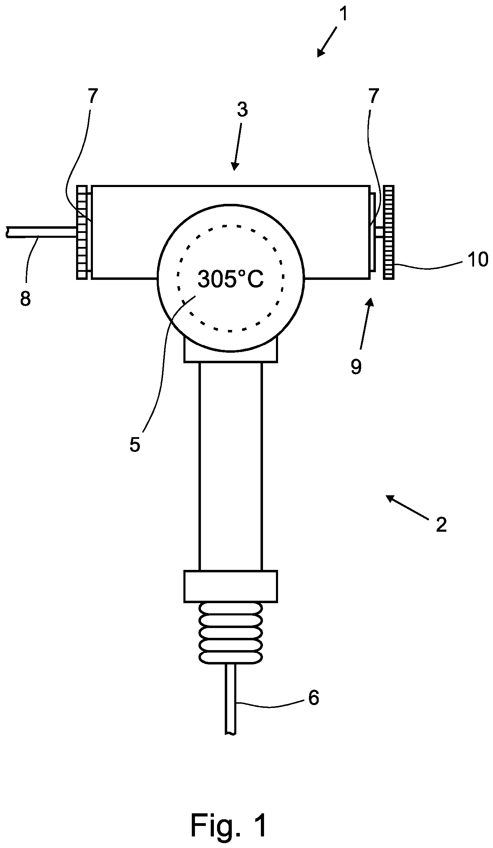

Fig. 1 zeigt ein erstes Ausführungsbeispiel eines Transmitters 1 und eines Feldgeräts 2. Der Transmitter 1 weist ein Transmittergehäuse 3, eine innerhalb des Transmittergehäuses 3 angeordnete Elektronikeinheit 4 und eine Anzeigeeinheit 5 auf. Die hier nicht dargestellte Elektronikeinheit 4 ist mit einem Messwertaufnehmer 6, der im dargestellten Ausführungsbeispiel als widerstands- oder spannungsabhängiger Sensor zur Temperaturmessung ausgebildet ist, verbunden.

Zudem weist das Transmittergehäuse 3 zwei Kabelverschraubungen 7 auf, die jeweils als Panzergewindeverschraubung ausgestaltet sind. Über die erste Kabelverschraubung 7 ist ein Stromkabel 8 in das Innere des Transmittergehäuses 3 geführt, das mit der Elektronikeinheit 4 verbunden ist. In die zweite Kabelverschraubung 7 ist ein Verbindungsmodul 9 umfassend ein Bedienelement 10 eingeschraubt. Das Bedienelement 10 ist im dargestellten Ausführungsbeispiel als Drehgeber bzw. als Encoder ausgebildet.

Das Bedienelement 10 ist über eine Kabelverbindung 11 mit der Anzeigeeinheit 5 verbunden, sodass der Nutzer des Feldgerätes 2 über das Bedienelement 10 die Anzeige der Anzeigeeinheit 5 auswählen und/oder steuern kann.

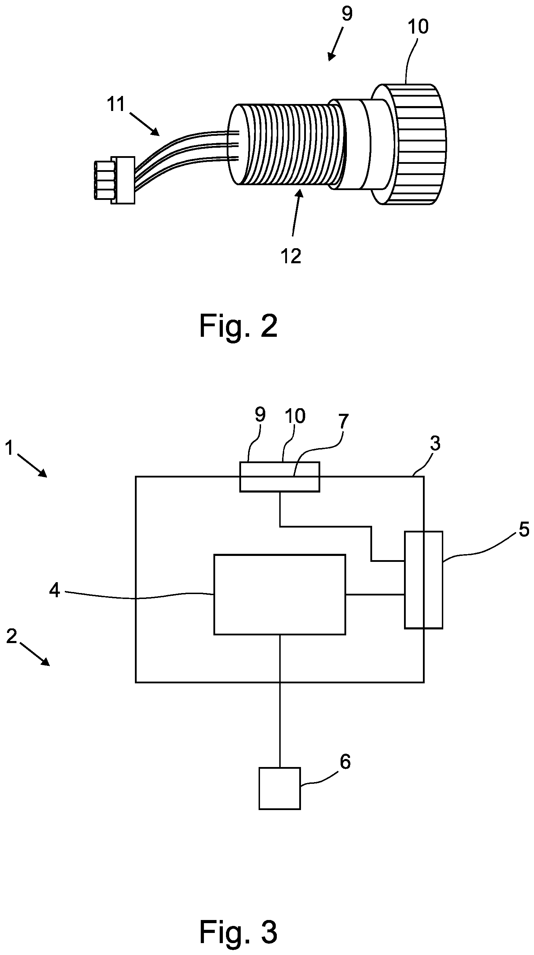

In Fig. 2 ist ein Ausführungsbeispiel eines Verbindungsmoduls 9 dargestellt, wobei das Bedienelement 10 als Drehgeber bzw. Encoder ausgebildet ist. Das Verbindungsmodul 9 weist zur Anbindung an die Kabelverschraubung 7 des Transmittergehäuses 3 ein Gewinde 12 auf, das mittels eines Spritzgussverfahrens an das Verbindungsmodul 9 angespritzt ist. Zur Anbindung an die Anzeigeeinheit 5 weist das Verbindungsmodul 9 entsprechende Verbindungskabel 11 auf. Insgesamt bildet das Verbindungsmodul 9 einen Stopfen, mit dem die Kabelverschraubung 7 dicht verschlossen ist.

Fig. 3 zeigt in schematischer Ansicht ein weiteres Ausführungsbeispiel eines Transmitters 1 bzw. eines Feldgeräts 2. Der Transmitter 1 umfasst ein Transmittergehäuse 3, in dem eine Elektronikeinheit 4 angeordnet ist, wobei die Elektronikeinheit 4 mit einem Messwertaufnehmer 6 verbunden ist. Zudem ist die Elektronikeinheit 4 mit einer Anzeigeeinheit 5 verbunden.

Das Transmittergehäuse 3 weist eine Kabelverschraubung 7 auf, in die ein Verbindungsmodul 9 eingeschraubt ist. Zur Bedienung der Anzeigeeinheit 5 weist das Verbindungsmodul 9 ein Bedienelement 10 auf, das mit der Anzeigeeinheit 5 verbunden ist. Das Bedienelement 9 kann im dargestellten Ausführungsbeispiel als Drehgeber bzw. Encoder oder auch als Taste oder als Druckknopf oder als Wippenschalter oder als Kippschalter oder als Drehschalter oder als Schieberegler oder als Fingerdrucksensor oder als optischer Sensor oder als Mikrofon oder als Steuerhebel ausgebildet sein.

Das Bedienelement 10 kann entweder unmittelbar durch den Nutzer des Feldgeräts 2 betätigt werden oder es kann ein Element zur drahtlosen Kommunikation in Form einer Buetooth-Antenne oder eine Antenne zur NFC-Kommunikation aufweisen.

Gemäß einem alternativen Ausführungsbeispiel ist das Bedienelement 10 alternativ oder zusätzlich mit der Elektronikeinheit 4 verbunden, sodass auch eine Kommunikation mit der Elektronikeinheit 4 gewährleistet ist.

Im Ergebnis gewährleistet der dargestellte Transmitter bzw. das dargestellte Feldgerät eine besonders einfache und sichere Bedienung der Anzeigeeinheit und/oder des Feldgeräts.

### Bezugszeichen

- 1: Transmitter
- 2: Feldgerät
- 3: Transmittergehäuse
- 4: Elektronikeinheit
- 5: Anzeigeeinheit
- 6: Messwertaufnehmer
- 7: Kabelverschraubung
- 8: Stromkabel
- 9: Verbindungsmodul
- 10: Bedienelement
- 11: Verbindungskabel
- 12: Gewinde

## Patentansprüche

1. Transmitter (1) mit einem Transmittergehäuse (3), einer Elektronikeinheit (4) und einer Anzeigeeinheit (5), wobei die Elektronikeinheit (4) zur Anbindung an einen Messwertaufnehmer (6) ausgebildet ist, wobei die Elektronikeinheit (4) mit der Anzeigeeinheit (5) verbunden ist und wobei das Transmittergehäuse (3) wenigstens eine Kabelverschraubung (7) aufweist,
**dadurch gekennzeichnet,**
**dass** in der wenigstens einen Kabelverschraubung (7) wenigstens ein Verbindungsmodul (9) angeordnet ist und dass das wenigstens eine Verbindungsmodul (9) wenigstens ein Bedienelement (10) zur Kommunikation mit der Anzeigeeinheit (5) und/oder der Elektronikeinheit (4) umfasst.

2. Transmitter (1) nach Anspruch 1, **dadurch gekennzeichnet, dass** die Kabelverschraubung (7) als Panzergewindeverschraubung ausgebildet ist.

3. Transmitter (1) nach einem der Ansprüche 1 oder 2, **dadurch gekennzeichnet, dass** das Verbindungsmodul (9) ein Gewinde aufweist und dass das Verbindungsmodul (9) in die Kabelverschraubung derart eingeschraubt ist, dass das Verbindungsmodul als Stopfen die Kabelverschraubung (7) dicht verschließt.

4. Transmitter (1) nach einem der Ansprüche 1 bis 3, **dadurch gekennzeichnet, dass** das wenigstens eine Bedienelement (10) ein analoges Bedienelement und/oder ein digitales Bedienelement umfasst.

5. Transmitter (1) nach einem der Ansprüche 1 bis 4, **dadurch gekennzeichnet, dass** das wenigstens eine Bedienelement (10) als Taste und/oder als Druckknopf und/oder als Wippenschalter und/oder als Kippschalter und/oder als Drehschalter und/oder als Schieberegler und/oder als Fingerdrucksensor und/oder als optischer Sensor und/oder als Mikrofon und/oder als Steuerhebel ausgebildet ist.

6. Transmitter (1) nach einem der Ansprüche 1 bis 5, **dadurch gekennzeichnet, dass** das Verbindungsmodul (9) wenigstens eine drahtlose Schnittstelle und/oder eine Antenne und/oder eine optische Schnittstelle aufweist.

7. Transmitter (1) nach einem der Ansprüche 1 bis 6, **dadurch gekennzeichnet, dass** das Verbindungsmodul (9) austauschbar in der Kabelverschraubung angeordnet ist.

8. Transmitter (1) nach einem der Ansprüche 1 bis 7, **dadurch gekennzeichnet, dass** die Anzeigeeinheit (5) in dem Verbindungsmodul (9) angeordnet ist.

9. Feldgerät (2) mit einem Messwertaufnehmer (6) und einem Transmitter (1), wobei der Transmitter (1) ein Transmittergehäuse (3), eine Elektronikeinheit (4) und eine Anzeigeeinheit (5) aufweist, wobei die Elektronikeinheit (4) mit dem Messwertaufnehmer (6) verbunden ist, wobei die Elektronikeinheit (4) mit der Anzeigeeinheit (5) verbunden ist und wobei das Transmittergehäuse (3) wenigstens eine Kabelverschraubung (7) aufweist,
**dadurch gekennzeichnet,**
**dass** in der wenigstens eine Kabelverschraubung (7) wenigstens ein Verbindungsmodul (9) angeordnet ist und dass das wenigstens eine Verbindungsmodul (9) wenigstens ein Bedienelement (10) zur Kommunikation mit der Anzeigeeinheit (5) und/oder der Elektronikeinheit (4) umfasst.

10. Feldgerät (2) nach Anspruch 9, **dadurch gekennzeichnet, dass** der Transmitter (1) nach einem der Ansprüche 1 bis 8 ausgebildet ist.

## Claims

1. Transmitter (1) having a transmitter housing (3), an electronics unit (4) and a display unit (5), wherein the electronics unit (4) is designed for connection to a measured value sensor (6), wherein the electronics unit (4) is connected to the display unit (5), and wherein the transmitter housing (3) has at least one cable gland (7),
**characterized in**
**that** at least one connection module (9) is arranged in the at least one cable gland (7), and that the at least one connection module (9) comprises at least one operating element (10) for communication with the display unit (5) and/or the electronics unit (4).

2. Transmitter (1) according to claim 1, **characterized in that** the cable gland (7) is designed as a threaded armor cable gland.

3. Transmitter (1) according to any one of claims 1 or 2, **characterized in that** the connection module (9) has a threading and that the connection module (9) is screwed into the cable gland in such a way that the connection module acts as a plug to tightly close the cable gland (7).

4. Transmitter (1) according to any one of claims 1 to 3, **characterized in that** the at least one operating element (10) comprises an analog operating element and/or a digital operating element.

5. Transmitter (1) according to any one of claims 1 to 4, **characterized in that** the at least one operating element (10) is designed as a key and/or as a push-button and/or as a rocker switch and/or as a toggle switch and/or as a rotary switch and/or as a slide controller and/or as a finger pressure sensor and/or as an optical sensor and/or as a microphone and/or as a control lever.

6. Transmitter (1) according to any one of claims 1 to 5, **characterized in that** the connection module (9) comprises at least one wireless interface and/or an antenna and/or an optical interface.

7. Transmitter (1) according to any one of claims 1 to 6, **characterized in that** the connection module (9) is interchangeably arranged in the cable gland.

8. Transmitter (1) according to any one of claims 1 to 7, **characterized in that** the display unit (5) is arranged in the connection module (9).

9. Field device (2) having a measured value sensor (6) and a transmitter (1), wherein the transmitter (1) has a transmitter housing (3), an electronics unit (4) and a display unit (5), wherein the electronics unit (4) is connected to the measured value sensor (6), wherein the electronics unit (4) is connected to the display unit (5), and wherein the transmitter housing (3) has at least one cable gland (7),
**characterized in**
**that** at least one connection module (9) is arranged in the at least one cable gland (7), and that the at least one connection module (9) comprises at least one operating element (10) for communication with the display unit (5) and/or the electronics unit (4).

10. Field device (2) according to claim 9, **characterized in that** the transmitter (1) is designed according to any one of claims 1 to 8.

## Revendications

1. Emetteur (1), comprenant un boîtier d'émetteur (3), une unité électronique (4) et une unité d'affichage (5), l'unité électronique (4) étant réalisée pour être raccordée à un transducteur (6), l'unité électronique (4) étant reliée à l'unité d'affichage (5), et le boîtier d'émetteur (3) présentant au moins un passe-câble à vis (7),
**caractérisé en ce qu'**au moins un module de connexion (9) est disposé dans ledit au moins un passe-câble à vis (7), et **en ce que** ledit au moins un module de connexion (9) comprend au moins un élément de commande (10) pour communiquer avec l'unité d'affichage (5) et/ou l'unité électronique (4).

2. Emetteur (1) selon la revendication 1, **caractérisé en ce que** le passe-câble à vis (7) est réalisé sous la forme d'un vissage à filetage PG.

3. Emetteur (1) selon l'une quelconque des revendications 1 ou 2, **caractérisé en ce que** le module de connexion (9) présente un filetage, et **en ce que** le module de connexion (9) est vissé dans le passe-câble à vis de telle sorte que le module de connexion sous forme de bouchon ferme le passe-câble à vis (7) de manière étanche.

4. Emetteur (1) selon l'une quelconque des revendications 1 à 3, **caractérisé en ce que** ledit au moins un élément de commande (10) comprend un élément de commande analogique et/ou un élément de commande numérique.

5. Emetteur (1) selon l'une quelconque des revendications 1 à 4, **caractérisé en ce que** ledit au moins un élément de commande (10) est réalisé sous forme de touche et/ou de bouton-poussoir et/ou d'interrupteur à bascule et/ou d'interrupteur inverseur et/ou d'interrupteur rotatif et/ou de curseur et/ou de capteur d'empreinte digitale et/ou de capteur optique et/ou de microphone et/ou de levier de commande.

6. Emetteur (1) selon l'une quelconque des revendications 1 à 5, **caractérisé en ce que** le module de connexion (9) présente au moins une interface sans fil et/ou une antenne et/ou une interface optique.

7. Emetteur (1) selon l'une quelconque des revendications 1 à 6, **caractérisé en ce que** le module de connexion (9) est disposé de manière échangeable dans le passe-câble à vis.

8. Emetteur (1) selon l'une quelconque des revendications 1 à 7, **caractérisé en ce que** l'unité d'affichage (5) est disposée dans le module de connexion (9).

9. Appareil de terrain (2), comprenant un transducteur (6) et un émetteur (1), l'émetteur (1) présentant un boîtier d'émetteur (3), une unité électronique (4) et une unité d'affichage (5), l'unité électronique (4) étant reliée au transducteur (6), l'unité électronique (4) étant reliée à l'unité d'affichage (5), et le boîtier d'émetteur (3) présentant au moins un passe-câble à vis (7),
**caractérisé en ce qu'**au moins un module de connexion (9) est disposé dans ledit au moins un passe-câble à vis (7), et **en ce que** ledit au moins un module de connexion (9) comprend au moins un élément de commande (10) pour communiquer avec l'unité d'affichage (5) et/ou l'unité électronique (4).

10. Appareil de terrain (2) selon la revendication 9, **caractérisé en ce que** l'émetteur (1) est réalisé selon l'une quelconque des revendications 1 à 8.
